# EUROPEAN PATENT APPLICATION

(11) **EP 1 309 047 A1**
(43) Date of publication of application: **07.05.2003**
(21) Application number: 01309404.0
(22) Date of filing: 06.11.2001
(51) Int. Cl.: H01S 5/022, H01L 23/66

(54) **Housing part for an optoelectronic device and manufacturing method thereof**

(71) Applicant: Agilent Technologies, Inc. (a Delaware corporation), Palo Alto, CA 94303 (US)
(72) Inventor: Owen, Martyn Robert, Diss, Norfolk IP22 1PD (GB); Gregory, Jason, Bury St Edmonds, Suffolk IP30 (GB)
(74) Representative: Coker, David Graeme

(57) **Abstract**

In order to provide communication of electrical signals between an interior and exterior of a co-axial package for an optoelectronic device, a CD header is typically employed, the CD header having leads passing therethrough. However, operation of the optoelectronic device at high data rates is impaired by parasitic capacitances caused by the CD header. There is also a need to prevent egress of Electromagnetic Interference (EMI) from the interior of the package and/or a need to prevent ingress of EMI to the interior if the package. One embodiment of the present invention therefore provides a CD header (104) having an aperture (106) filled by a laminate block (112) comprising layers of ceramic material having metallised layers (126) disposed between a number of the layers of ceramic. Vias (128) also pass through the number of layers of ceramic in order to form a mesh structure that can act as a screen to EMI. In order to permit communication of electrical signals into and out of the package, one or more electrical conductor (120) is sandwiched between two adjacent layers of ceramic material forming the laminate block.

## Description

The present invention relates to a housing for an optoelectronic device package, for example a CD header, of the type used, for example, in an optical communications system. The present invention also relates to a method of manufacturing the above housing part.

In the field of optoelectronics, it is known to site optoelectronic devices, such as laser diodes or photodiodes, within a protective package. Known packages are formed from metal, such as Kovar, which shields or suppresses electromagnetic Interference (EMI). One particular type of package, known as an optical co-axial package, is formed from Kovar and comprises an opening at a first end for coupling to an optical fibre and an opening at a second end, the opening being closed by a Kovar disc, known as a CD header. The CD header comprises a number of circular apertures through which Kovar wires pass to provide electrical connections between components and/or devices contained within the optical co-axial package and electrical components and/or devices external to the optical co-axial package. The Kovar wires are insulated from the CD header by respectively filling gaps between the Kovar wires and the periphery of the circular apertures with low melting point sealing glass.

Parasitic capacitances are known to exist, caused by the CD header/sealing glass/Kovar wire combinations. Due to the manufacturing tolerances of the diameters of the circular apertures, the Kovar wire diameters and the positioning of the Kovar wires relative to the periphery of the circular apertures, the parasitic capacitances are unpredictably inconsistent. Additionally, the lengths of the Kovar wires give rise to inductances. Consequently, in the case of the optical co-axial package housing a laser diode, the performance of the laser diode at data rates greater than 2.5 Gbps begins to degrade such that the performance is unacceptable by 10 Gbps.

According to a first aspect of the present invention, there is provided a housing part for an optoelectronic device package, the housing part comprising a first side, a second side and an aperture communicating between the first and second sides; a first layer of electrically insulating material disposed adjacent a second layer of electrically insulating material; an electrical conductor sealingly disposed between the first and second layers of electrically insulating material for communicating electrical signals between the first and second sides; characterised by a third layer of electrically insulating material disposed adjacent the second layer of electrically insulating material, the aperture being closed by the first and second and third layers of electrically insulating material; and a first layer of electrically conductive material and a second layer of electrically conductive material respectively disposed either side of the third layer of electrically insulating material.

Preferably, the first and second layers of electrically insulating material are ceramic.

Preferably, the first and second layers of electrically conductive material are thin layers of metallisation. The thickness of the thin layers of metallisation may be as thin as about 2µm or more, preferably 3µm, but may be much thicker.

Preferably, the housing part further comprises at least one electrically conductive via extending through the third layer of electrically insulating material so as to connect electrically the first and second layers of electrically conductive material. More preferably, the at least one electrically conductive via is metallised.

Preferably, the outer surfaces of one of the at least one electrically conductive via and another of the at least one electrically conductive via are spaced at least 150µm apart.

Preferably, the first layer of electrically insulating material extends beyond the first and/or the second side.

Preferably, the second layer of electrically insulating material extends beyond the first and/or the second side.

In one embodiment of the invention, the housing part is a header, preferably a CD header.

In another embodiment of the invention, the housing part is a butterfly package without a lid and the butterfly package without the lid comprises the third layer of electrically insulating material and the at least one electrically conductive via as set forth above in accordance with the present invention.

According to a second aspect of the present invention, there is also provided a header for an optoelectronic device package, the header comprising a first side, a second side and an aperture communicating between the first and second sides; characterised by a first layer of electrically insulating material disposed adjacent a second layer of electrically insulating material so as to close the aperture, an electrical conductor being sealingly disposed between the first and second layers of electrically insulating material for communicating electrical signals between the first and second sides.

According to a third aspect of the present invention, there is also provided a method of manufacturing a housing part having an electrically conductive path therethrough, the method comprising the steps of: forming a first layer and a second layer of electrically insulating material; providing the housing part having a first side, a second side and an aperture communicating between the first and second sides; sealingly disposing an electrical conductor between the first and second layers of electrically insulating material for communicating electrical signals between the first and second sides; characterised by: providing a third layer of electrically insulating material; respectively disposing a first layer of electrically conductive material and a second layer of electrically conductive material either side of the third layer of insulating material; assembling the first and second layers of electrically insulating material so as to be adjacent one another; disposing the third layer of electrically insulating material adjacent the second layer of electrically insulating material; closing the aperture with the first and second and third layers of insulating material.

Preferably, the method further comprises the step of: forming at least one electrically conductive via through the third layer of electrically insulating material so as to electrically connect the first and second electrically conductive layers.

Preferably, the method further comprises the step of: forming at least one electrically conductive via through the first and/or second layer of electrically insulating material.

According to a fourth aspect of the present invention, there is also provided a method of manufacturing a header having an electrically conductive path therethrough, the method comprising the steps of: forming a first layer and a second layer of electrically insulating material; sealingly disposing an electrical conductor between the first and second layers of electrically insulating material for communicating electrical signals between the first and second sides; assembling the first and second layers of electrically insulating material so as to be adjacent one another, characterised by: providing the header having a first side, a second side and an aperture communicating between the first and second sides; closing the aperture with the first and second layers of insulating material.

As in the first embodiment described above, the header used in the above method is preferably a CD header.

It is thus possible to provide at least one electrical conductor for communicating signals between the interior and exterior of a package for an optoelectronic device, or any device requiring shielding from EMI. The housing part still allows hermetic sealing of the package, but permits the use of smaller, less expensive, package types for high frequency applications. In this respect, the housing part does not result in unpredictable parasitic capacitances that can affect operation of a device, for example a semiconductor laser, within the package at operating frequencies of, for example above 2.5 Gbps. In addition, prevention, or at the very least minimisation, of ingress of EMI to the interior of the package or egress of EMI from the interior of the package is possible.

At least one embodiment of the invention will now be described, by way of example only, with reference to the accompanying drawings, in which:
**Figure 1** is an isometric view of a package comprising a housing part constituting an embodiment of the present invention;
**Figure 2** is a view of a wall of the package of Figure 1 in cross-section along line A-A;

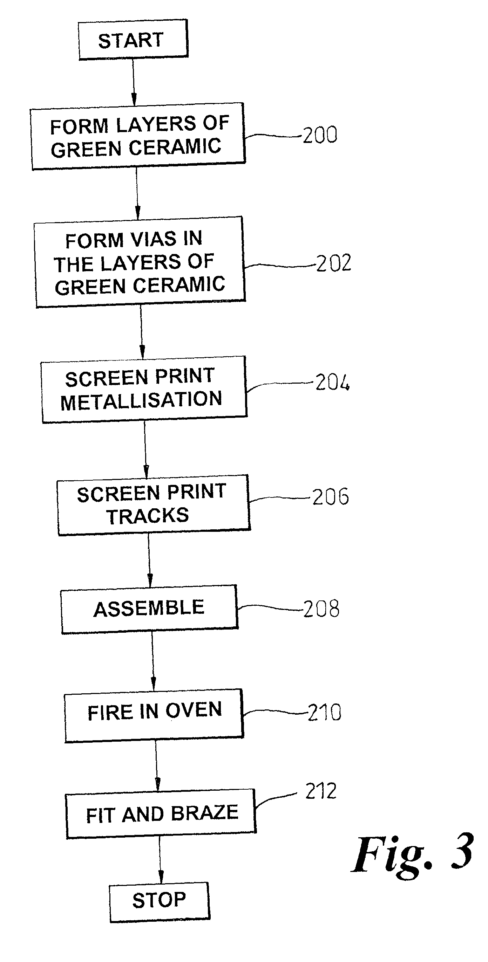

**Figure 3** is flow diagram of a method of manufacture of the housing part of Figure 2.

Throughout the following description, identical reference numerals will be used to identify like parts.

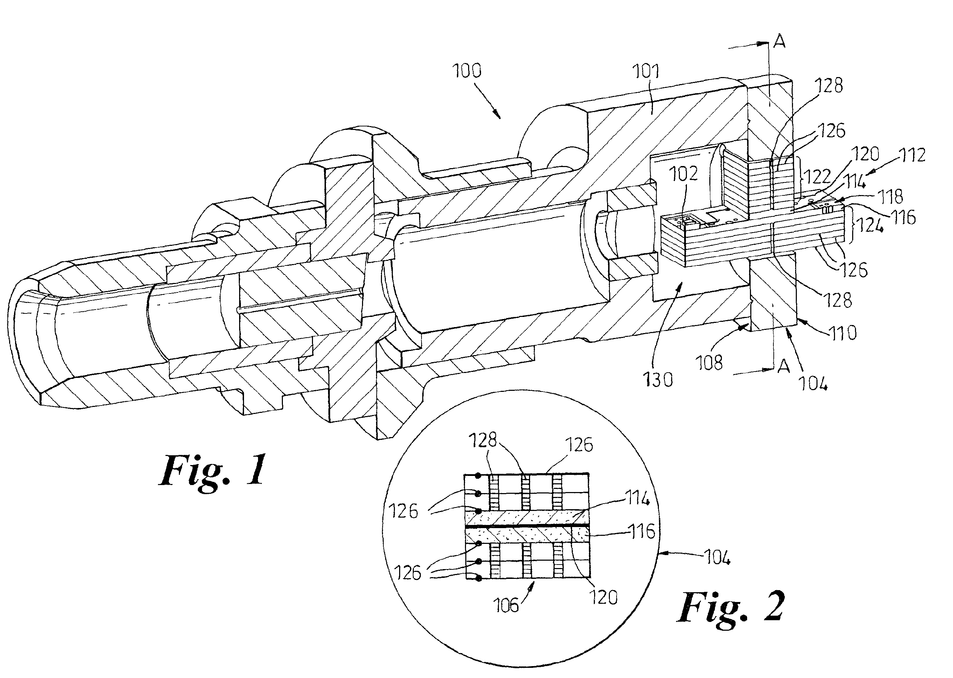

Referring to Figure 1, a package 100 is a hermetically sealed co-axial optical package and, in this example, contains a semiconductor laser 102. Such co-axial packages are produced by Agilent® Technologies, Inc. The package 100 comprises a body 101, and a header that seals the body 101 at one end thereof. In this example the header is a CD header 104. As the invention does not relate to the structure of the body 101 of the package 100, the structure of the body 101 will not be described in further detail.

The CD header 104 comprises a square aperture 106. In this example, the square aperture 106 is used for convenience, but it should be appreciated that any shape of aperture can be used. The aperture 106 communicates a first side 108 of the CD header with a second side 110 of the CD header 104. The aperture 106 is closed by laminate block 112 comprising a plurality of layers of insulating material, in this example cofired ceramic. A first central layer of ceramic 114 is disposed adjacent a second central layer of ceramic 116. A closest surface 118 of the second layer of ceramic 116 to the first layer of ceramic 114 comprises one, or more, track 120 printed thereon and interposed between the first and second central layers of ceramic 114, 116. The layout of the one or more track 120 is such that impedance generated by the one or more track 120 can be carefully controlled up to a highest required operating frequency.

A first number of layers of ceramic 122 and a second number of layers of ceramic 124 are respectively disposed either side of the first and second central layers of ceramic 114, 116. In this example, the second central layer 116 and the second number of layers of ceramic 124 extend beyond the first and second sides 108, 110 of the header 104. Layers of electrically conductive material 126 are respectively disposed on both sides of the layers of ceramic forming the first and second number of layers of ceramic 122, 124. In this example, the layers of electrically conducted material are metallised layers.

One or more vias, in this example a plurality of vias 128 extend vertically between the layers of electrically conductive material so as to interconnect the metallised layers 126 and form a reticulated structure with the metallised layers 126. In this example, the reticulated structure is a mesh. The vias 116 are also metallised, or filled substantially completely with a conductive material.

Referring to Figure 2, the diameter of the vias 126 is between 0.2mm and 0.5mm. In this example, the spacing between outer surfaces of adjacent vias 126 is from about 150µm upwards, but can be less, depending upon the frequency of the EMI that one wants to block. The mesh structure in combination with the CD header 104 and the metallic co-axial housing 100 form a Faraday cage structure that blocks ingress of electromagnetic radiation to an interior 130 of the package 100 or egress of electromagnetic radiation from the interior of the package 100. The vias 126 are coupled to electrical ground potential through the CD header 104 thereby enabling the Faraday cage structure to act as a Faraday cage for the interior 130.

Manufacture of the package is as follows. A plurality of layers of, in this example, green ceramic are formed (Step 200) which, when laminated together, will have a rectangular shape that fits the aperture 106. In this example, the green ceramic is Aluminium Nitride. Vias (not shown) are formed (Step 202) through a first and second number of the layers of green ceramic corresponding to the first and second number of layers of ceramic 122, 124 so that when assembled as a laminate two central layers of green ceramic corresponding to the first and second central layers 114, 116 are sandwiched between the first and second number of layers of green ceramic having the vias 116 formed therethrough. Upper and lower surfaces of the first and second number of layers of green ceramic are screen printed (Step 204) with a metallisation compound, for example, containing tungsten particles. A surface of the second central layer of green ceramic corresponding to the closest surface 118 is screen printed (Step 206) with the one or more track 120 such that when adjacent the first central layer of green ceramic, the one or more track 120 is interposed between the first and second central layers of green ceramic. If required, circuit tracks can be printed on the surface of the second central layer of green ceramic. Furthermore, it should be understood that the first and second central layer of greed ceramic need not be disposed centrally between the first and second number of layers of ceramic 114, 116 and, consequently, the first and second layers of ceramic 114, 116 need not be of a same thickness.

The vias (not shown) formed in each of the first and second number of layers of green ceramic are also filled with the metallisation compound. The layers of the green ceramic are then assembled (Step 208) to form the structure of the laminate block 112. The assembled structure or laminate block 112 is then fired (Step 210) in an oven for a predetermined period of time (as is known in the art) in order to harden the green ceramic.

Once cooled, the laminate is fitted (Step 212) into the aperture 106 and secured in the aperture 106 by brazing.

In another embodiment of the invention, the square aperture 106 can be a narrow slot and the narrow slot can be filled by an alternatively structured laminate block (not shown) comprising only the first and second central layers of ceramic 114, 116 and the one or more track 120.

In other embodiments of the invention, other types of package can be provided with the laminate block 112 described above in connection with Figures 1 and 2. For example, one or more ceramic side feed-through of a butterfly package can be replaced with the laminate block 112.

## Claims

1. A housing part (104) for an optoelectronic device package (100), the housing part (104) comprising a first side (108), a second side (110) and an aperture (106) communicating between the first and second sides (108, 110); a first layer of electrically insulating material (114) disposed adjacent a second layer of electrically insulating material (116); an electrical conductor (118) sealingly disposed between the first and second layers of electrically insulating material (114, 116) for communicating electrical signals between the first and second sides (108, 110); **characterised by** a third layer of electrically insulating material disposed adjacent the second layer of electrically insulating material (116), the aperture (106) being closed by the first and second and third layers of electrically insulating material; and a first layer of electrically conductive material (126) and a second layer of electrically conductive material (126) respectively disposed either side of the third layer of electrically insulating material.

2. A housing part as claimed in Claim 1, wherein the first and second layers of electrically insulating material (114, 116) are ceramic.

3. A housing part as claimed in Claim 1 or Claim 2, wherein the first and second layers of electrically conductive material (126) are thin layers of metallisation.

4. A housing part as claimed in any one of the preceding claims, further comprising at least one electrically conductive via (128) extending through the third layer of electrically insulating material so as to connect electrically the first and second layers of electrically conductive material (126).

5. A housing part as claimed in Claim 4, wherein the at least one electrically conductive via (128) is metallised.

6. A housing part as claimed in Claim 4 or Claim 5, wherein the outer surfaces of one of the at least one electrically conductive via (128) and another of the at least one electrically conductive via (128) are spaced at least 150µm apart.

7. A housing part as claimed in any one of the preceding claims, wherein the first layer of electrically insulating material (114) extends beyond the first and/or the second side.

8. A housing part as claimed in any one of Claims 1 to 7, wherein the second layer of electrically insulating material (116) extends beyond the first and/or the second side.

9. A housing part as claimed in any one of the preceding claims, wherein the housing part is a header.

10. A housing part as claimed in any one of Claims 5 to 8, wherein the housing part is a butterfly package without a lid.

11. A header (104) for an optoelectronic device package (100), the header (104) comprising a first side (108), a second side (110) and an aperture (116) communicating between the first and second sides (108, 110); **characterised by** a first layer of electrically insulating material (114) disposed adjacent a second layer of electrically insulating material (116) so as to close the aperture (106), an electrical conductor (120) being sealingly disposed between the first and second layers of electrically insulating material (114, 116) for communicating electrical signals between the first and second sides (118, 110).

12. A method of manufacturing a housing part (104) having an electrically conductive path therethrough, the method comprising the steps of:
forming (200) a first layer and a second layer of electrically insulating material (114, 116);
providing the housing part (104) having a first side (108), a second side (110) and an aperture (106) communicating between the first and second sides (108, 110);
sealingly disposing (206) an electrical conductor between the first and second layers of electrically insulating material (114, 116) for communicating electrical signals between the first and second sides (108, 110); **characterised by**:
providing a third layer of electrically insulating material;
respectively disposing (204) a first layer of electrically conductive material (126) and a second layer of electrically conductive material (126) either side of the third layer of insulating material;
assembling (208) the first and second layers of electrically insulating material (114, 116) so as to be adjacent one another;
disposing the third layer of electrically insulating material adjacent the second layer of electrically insulating material (116);
closing the aperture (106) with the first and second and third layers of insulating material.

13. A method as claimed in Claim 12, further comprising the step of:
forming (202) at least one electrically conductive via (128) through the third layer of electrically insulating material so as to electrically connect the first and second electrically conductive layers (126).

14. A method as claimed in Claim 12 or Claim 13, further comprising the step of:
forming at least one electrically conductive via through the first and/or second layer of electrically insulating material.

15. A method of manufacturing a header (104) having an electrically conductive path therethrough, the method comprising the steps of:
forming (200) a first layer and a second layer of electrically insulating material (114, 116);
sealingly disposing (206) an electrical conductor (126) between the first and second layers of electrically insulating material (114, 116) for communicating electrical signals between the first and second sides (108, 110);
assembling (208) the first and second layers of electrically insulating material (114, 116) so as to be adjacent one another, **characterised by**:
providing the header (104) having a first side (108), a second side (110) and an aperture (106) communicating between the first and second sides (108, 110);
closing the aperture with the first and second layers of insulating material.
